(19) Europäisches Patentamt
European Patent Office
Office européen des brevets

(11) **EP 4 672 299 A2**

(12) **EUROPEAN PATENT APPLICATION**

(43) Date of publication:
**31.12.2025 Bulletin 2026/01**

(21) Application number: **25176421.3**

(22) Date of filing: **14.05.2025**

(51) International Patent Classification (IPC):
***H01J 37/244*** (2006.01)     ***H01J 37/28*** (2006.01)

(52) Cooperative Patent Classification (CPC):
**H01J 37/28; H01J 37/244;** H01J 2237/2443

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **03.06.2024   DE 102024205080**

(71) Applicant: **Carl Zeiss MultiSEM GmbH 73447 Oberkochen (DE)**

(72) Inventors:
 • **Zeidler, Dirk**
   **73447 Oberkochen (DE)**
 • **Miksch, Bjoern**
   **73447 Oberkochen (DE)**
 • **Koch, Markus**
   **73447 Oberkochen (DE)**
 • **Schmid, Thomas**
   **73447 Oberkochen (DE)**
 • **Menke, Felix**
   **73447 Oberkochen (DE)**
 • **Dieterle, Thomas**
   **73447 Oberkochen (DE)**
 • **Mueller, Ingo**
   **73447 Oberkochen (DE)**
 • **Menke, Christoph**
   **73447 Oberkochen (DE)**

(74) Representative: **Tesch-Biedermann, Carmen Athene Patent Hanns-Schwindt-Straße 11 81829 München (DE)**

(54) **MULTI-BEAM CHARGED PARTICLE MICROSCOPE DESIGN WITH ADAPTIVE DETECTION SYSTEM**

(57)     A multi-beam charged particle beam system with a detection unit is provided, which is configured for a dynamic compensation of charging effects of a sample. The detection unit comprises a relay optical system comprising an adaptive mirror array for keeping signal beams at the position of entrance apertures of lightguides od detection elements. Thereby, beam distortions induced by charging effects are compensated. The invention can be applied for wafer inspection with multi-beam charged particle beam system.

FIG. 5a

EP 4 672 299 A2

## Description

## Field of the invention

The disclosure relates to a multi-beam charged particle microscope with reduced improved imaging contrast and a method for the inspection of semiconductor features with improved image contrast.

## Background of the invention

WO 2005/024881 A2 discloses an electron microscope system which operates with a multiplicity of electron beamlets for the parallel scanning of an object to be inspected with a bundle of electron beamlets. The bundle of primary charged particle beamlets is generated by directing a primary charged particle beam onto a multi-beam forming unit, comprising at least one multi-aperture plate, which has a multiplicity of openings. One portion of the electrons of the electron beam is incident onto the multi-aperture plate and is absorbed there, and another portion of the beam transmits the openings of the multi-aperture plate and thereby in the beam path downstream of each opening an electron beamlet is formed whose cross section is defined by the cross section of the opening. The primary charged particle beamlets are focused by an objective lens on a surface of a sample and trigger secondary electrons or backscattered electrons to emanate as secondary electron beamlets from the sample, which are collected and imaged onto a detector. Each of the secondary beamlets is incident onto a separate detector element or group of detector elements, so that the secondary electron intensities detected therewith provide information relating to the surface of the sample at the location where the corresponding primary beamlet is incident onto the sample. The bundle of primary beamlets is scanned systematically over the surface of the sample and an electron microscopic image of the sample is generated in the usual way of scanning electron microscopes.

Generally, the imaging contrast of a scanning electron microscope depends on the signal generated by secondary electrons, which depends on the secondary electron (SE) yield per primary electron and a geometrical collection efficiency of the electron microscope. The SE yield depends on material characteristics and the kinetic energy of the primary electrons. The secondary electron beamlets collected by the objective lens are then guided to a detector. The secondary electrons generated and extracted from the sample surface, however, are in many cases subject to charging effects at the sample surface, especially if the secondary electron yield is not in balance with the incident primary electron current. These charging effects lead to a deterioration of the secondary electron beamlets and to a reduced image contrast, an increase of cross-talk or even a complete loss of the secondary electron signal. Charging effects become more and more deteriorating the image contrast in wafer inspection tasks during fabrication of integrated circuits. Such wafers are comprising semiconductor materials, local capacities, and isolators, which may accumulate for example surface charges. In other examples, the target of an inspection task are wafers covered by photoresist, wherein photoresist accumulates local surface charges. Patent applications WO 2022/248141 A1 and DE 102022114923.4 disclose monitoring methods to detect charging effects at such charging samples. DE 102 018124044 B3 proposes a deconvolution of cross-talk. However, a deconvolution is only possible for minor charging effects. Generally, for a compensation of charging effects during the imaging of secondary electron beamlets, electron-optical means are required to maintain a high contrast at a secondary electron detector.

Different mechanisms have been proposed to improve an imaging contrast of a multi-beam electron microscope in presence of charging effects. US 11 049 686 BB, US 10 896 800 BB, US 10 811 215 B2 and WO 2021 239380 A1 propose an arrangement of several active electrostatic or magneto-dynamic elements within a secondary electron imaging system. However, these systems of the prior art are either of high complexity, or they do not allow a fast correction of deteriorated secondary electron beamlets with sufficient magnitude of correction. For example, US 10 811 215 B2 proposes secondary electron imaging system designs of high complexity, comprising up to nine electro-optical lenses.

However, many electron-optical solutions proposed for compensation of charging effects turn into very complex electron-optical systems. It is therefore a further demand to provide a secondary electron imaging system which provides more simple compensation means for charging effects. Furthermore, the increasing demand for higher throughput requires an improvement of a collection efficiency of the secondary electron signals.

## Description of the invention

The invention provides a multi-beam charged particle beam system and a method of operating a multi-beam charged particle beam system for image acquisition with higher imaging contrast and increased throughput even in presence of charging effects. The object of the invention is achieved by an improved imaging system design.

The present patent application claims the priority of German patent application No. 10 2024 205 080.6 filed on 3 June 2024, the disclosure of which in the full scope thereof is incorporated in the present patent application by reference.

In a first embodiment, a method of operating a multi-beam charged particle beam system is provided. The method is comprising the steps of

- forming a plurality of first focus spots of a plurality of primary charged particle beamlets in a first image plane,

- collecting a plurality of secondary electron beamlets and forming a plurality of second focus spots of the plurality of secondary electron beamlets in a second image plane,
- converting the plurality of second focus spots into a plurality of light beams and forming a plurality of third focus spots thereof in a third image plane,
- individually adjusting a position of at least one third focus spot, and
- receiving a plurality of intensity signals with a plurality of fast detection elements.

In an example, the steps are performed in parallel during an image acquisition. Thereby, a distortion of secondary electron beamlets during imaging, for example due to a charging effect of the surface of an object, are compensated.

In an example, the method is further comprising a step of monitoring the plurality of positions of the plurality of third focus spots with a high-resolution image sensor and determining a deviation in a position of at least one third focus spot from a pre-determined position. For example, the method is further comprising determining from the deviation at least one tilt angle of a mirror of an adaptive mirror array, and individually adjusting a position of at least one third focus spot by adjusting at least one tilt angle of at least one mirror of the adaptive mirror array.

In an example, the method is further comprising a step of adjusting a position or rotation angle of the plurality of entrance apertures of lightguides connected to the fast detection elements with a movement stage.

According to a second embodiment, a multi-beam charged particle beam system is comprising an object irradiation unit, configured for irradiation a surface of an object arranged in a first image plane with a plurality of first focus spots of a plurality of primary charged particle beamlets. The multi-beam charged particle beam system is further comprising a detection unit, configured for collecting a plurality of secondary electron beamlets excited at the plurality of first focus spots from the surface of the object, and forming a plurality of second focus spots of the plurality of secondary electron beamlets in a second image plane of the detection unit. The multi-beam charged particle beam system is further comprising an electron to photon conversion unit arranged in the second image plane of the detection unit and a relay optical system for imaging photons or light generated at the electron to photon conversion unit and for forming a plurality of third focus spots in a third image plane of the relay optical system. In the third image plane, a plurality of entrance apertures of lightguides are arranged. Each of the lightguides is connected to a fast detection element. In an example, the plurality of fast detection elements is directly arranged within the third image plane.

The relay optical system is further comprising an adaptive mirror array and a mirror control module configured for controlling the tilt angles of the plurality of mirrors of the adaptive mirror array such that the positions of the plurality of third focus points are kept constant at the plurality of entrance apertures of lightguides or fast detection elements during an image acquisition.

In an example, a multi-beam charged particle beam system is further comprising a monitoring system comprising a high-resolution sensor. The high-resolution sensor is arranged to receive an image of positions of the plurality of third focus points. For example, the relay optical system is comprising a beam divider mirror for diving the light and guiding the divided light of the plurality of light beams onto the high-resolution sensor. The mirror control module is configured to determine position deviations of the plurality of third focus points from the plurality of entrance apertures of lightguides or fast detection elements. In an example, the mirror control module is further configured to determine tilt angles of the adaptive mirror array from the position deviations.

In an example, the relay optical system has a magnification $M \geq 20$, for example $M = 30$, $M = 40$ or even more; thereby, a separation of the plurality of light beams and an individual control of each position of the plurality of third focus points is enabled. In an example, the adaptive mirror array is arranged at a distance L1 to the third image plane with $L1 \geq JX \times P1 / 2$, with JX being number of the plurality of beamlets in one lateral direction and P1 being pitch of third focus spots. In an example $L1 > 16.5mm$, for example $L1 > 45mm$, or for example $L1 > 80mm$. The distance L1 however has to be determined in accordance with the number JX of beamlets in one lateral direction and may not exceed a maximum distance of L1 max given by $L1 < L1\,max = P1 \times [1/NA1 - JX]/2$, with NA1 being the numerical aperture of a light beam at the third image plane. In an example, $L1 > 20mm$.

In an example, each of the plurality of mirrors is an individually and continuously tiltable mirror comprising at least one flexure and at least one actuator. In an example, the plurality of entrance apertures of lightguides or fast detection elements are mounted on a movement stage for adjustment of a lateral position or rotation angle of the plurality of entrance apertures of lightguides or fast detection elements with respect to the plurality of third focus spots. Thereby, a global rotation angle or a global lateral displacement of the plurality of third focus spots can be adjusted. The relay optical system may further comprise a zoom lens for adjusting a magnification of the relay optical system.

According to an embodiment, a multi-beam charged particle beam system is comprising a control unit with software code, causing the multi-beam charged particle beam system to perform a method according the first embodiment. In an example, the mirror control module is an ASIC programmed to execute method steps of determining a deviation in a position of at least one third focus spot from a pre-determined position, determining from the deviation at least one tilt angle of a mirror of an adaptive mirror array, and individually providing control signals to the adaptive mirror array for adjusting a position of at least one third focus spot by adjusting at least one tilt angle of at least one mirror of the adaptive mirror array.

By the embodiments or examples of the invention, a multi-beam charged particle beam system and a method of operating a multi-beam charged particle beam system with improved image contrast and improved image signal is provided. The invention allows therefore a wafer inspection, including charging wafer samples, with higher precision and with a higher accuracy. It will be understood that the invention is not limited to the embodiments and examples but comprises also combinations and variations of the embodiments and examples.

Brief description of the drawings

Embodiments of the present disclosure will be explained in more detail with reference to drawings, in which:

Fig. 1 is a schematic sectional view of a multi-beam charged particle beam system 1

Fig. 2 illustrates some details of a multi-beam charged particle beam system 1

Fig. 3 illustrates some further details of a multi-beam charged particle beam system 1

Fig. 4 illustrates a detector 600 with an optical relay system

Figs. 5a-d illustrate an optical relay system according to an embodiment

Figs. 6a-b illustrate some design constraints of an optical relay system according to an embodiment

Fig. 7 illustrates a method of operation according to an embodiment

Figs. 8a-c illustration of an example of the effect of the method

**Description of Exemplary Embodiments**

In the exemplary embodiments of the invention described below, components similar in function and structure are indicated as far as possible by similar or identical reference numerals.

Some array elements, for example the plurality of primary charged particle beamlets, are identified by a reference number. Depending on the context, the same reference number may also identify a single element out of the plurality of elements. Each primary charged particle beamlet (3.1, 3.2, 3.3) is one beamlet of the plurality of primary charged particle beamlets (3).

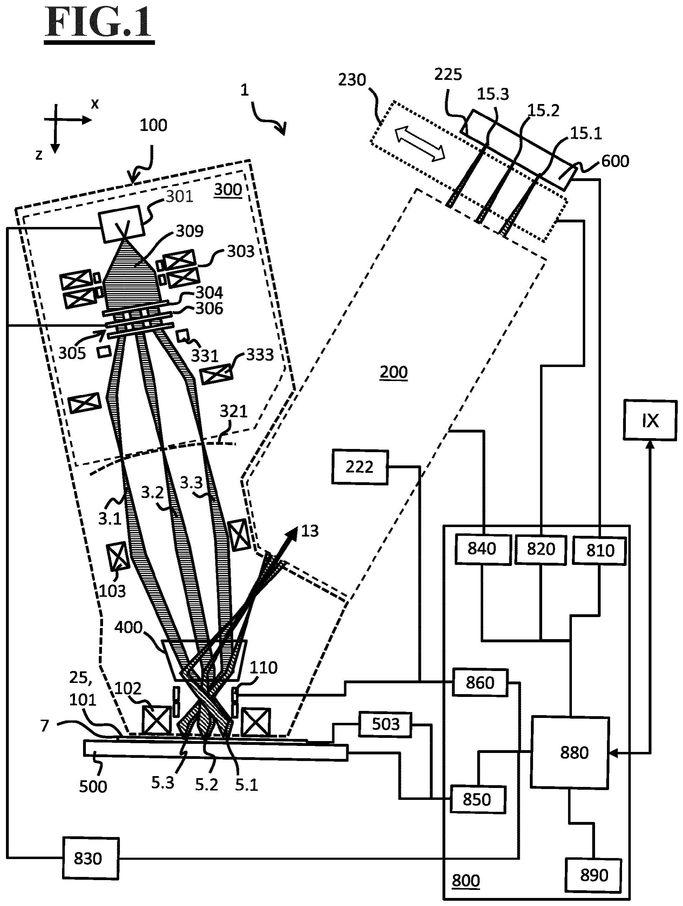

The schematic representation of **figure 1** illustrates basic features and functions of a multi-beam charged-particle system 1. It is to be noted that the symbols used in the figure have been chosen to symbolize their respective functionality. The type of system shown is that of a multi-beam scanning electron microscope using a plurality of primary charged particle beamlets 3 for generating a plurality of primary charged particle beam spots 5 on a surface 25 of an object 7, such as a wafer or mask substrate located with a top surface 25 in an object plane 101 of an objective lens 102. For simplicity, only three primary charged particle beamlets 3.1 to 3.3 and three primary charged particle beam spots 5.1 to 5.3 are shown. The features and functions of multi-beamlet charged-particle system 1 can be implemented using electrons or other types of primary charged particles such as ions and in particular Helium ions. Further details of the microscope system 1 are provided in International Patent application WO 2022262970 A1, filed on June 16, 2021, which is hereby fully incorporated by reference.

The system 1 comprises an object irradiation unit 100 and a detection unit 200 and a secondary electron beam divider or beam splitter unit 400 for separating the secondary charged-particle beam path 13 from the primary charged-particle beam path. The object irradiation unit 100 comprises a charged-particle multi-beam generator 300 for generating the plurality of primary charged-particle beamlets 3 and is adapted to focus the plurality of primary charged-particle beamlets 3 on the object plane 101, in which the surface 25 of an object or wafer 7 is positioned by a sample stage 500.

The primary beam generator 300 produces a plurality of primary charged particle beamlet spots in an intermediate image surface 321. The primary beamlet generator 300 comprises at least one source 301 of primary charged particles, for example electrons. The at least one primary charged particle source 301 emits a diverging primary charged particle beam, which is collimated by at least one collimating lens 303 to form a collimated or parallel primary charged particle beam 309. The collimating lens 303 is usually consisting of one or more electrostatic or magnetic lenses, or by a combination of electrostatic and magnetic lenses. The collimated primary charged particle beam 309 is incident on the primary multi-beam forming unit 305. A multi-beam generating unit 305 is for example explained in US 2019/0259575, and in US 10.741.355 B1, both hereby incorporated by reference. The multi-beam forming unit 305 basically comprises a first multi-aperture plate or filter plate 304 illuminated by the collimated primary charged particle beam 309. The first multi-aperture plate or filter plate 304 comprises a plurality of apertures in a raster configuration for generation of the plurality of primary charged particle beamlets 3, which are generated by transmission of the collimated primary charged particle beam 309 through the plurality of apertures. The multi-beamlet forming unit 305 comprises at least one further multi-aperture plate 306, which is located, with respect to the direction of movement of the electrons in beam 309, downstream of the first multi-aperture or filter plate 304. The multi-beamlet forming unit 305 is further configured with an adjacent electrostatic field lens 331, which is in some examples combined in the multi-beamlet forming unit 305. Together with a second field lens 333, the plurality of primary charged particle beamlets 3 is focused in or in proximity of the intermediate image surface 321. The primary charged-particle source 301 and each of the active multi-aperture plates 306 are controlled by control unit 830.

The plurality of focus points of primary charged particle beamlets 3, formed near the intermediate image surface 321, is imaged by field lens group 103 and objective lens 102 into the object plane 101, in which the surface 25 of the object 7 is positioned. A decelerating electrostatic field is generated between the objective lens 102 and the object surface 25 by application of a voltage to the object by the sample voltage supply 503. With the decelerating electrostatic field generated by sample voltage supply 503, a landing energy EL of primary electrons is adjusted to for example below 2keV, below 1keV, below 800eV, below 500 eV, below 300eV or even less.

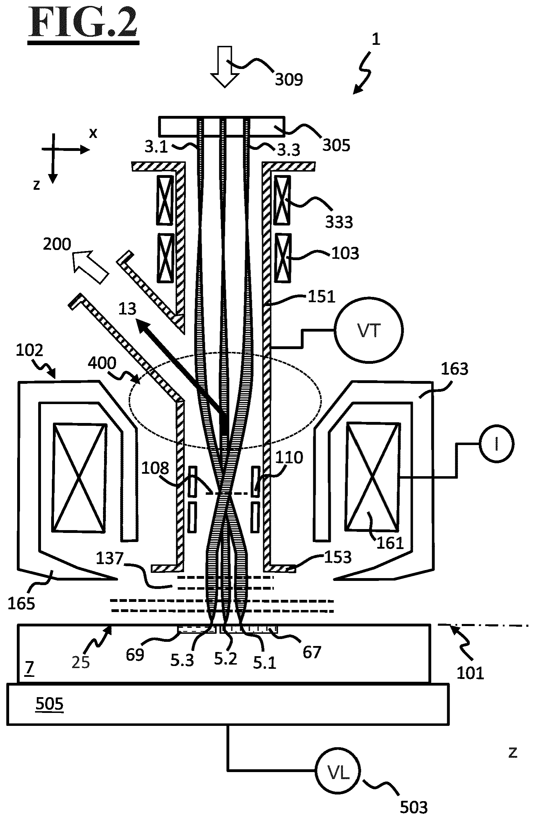

**Figure 2** illustrates further details of the decelerating electrostatic field generated. From a collimated electron beam 309, a plurality of primary charged particle beamlets 3 is generated by the multi-aperture arrangement 305. For simplicity, again only three beamlets 3.1 to 3.3 are shown in Figure 2, but there can be more beamlets, for example more than 60, more than 90, or even more than 300 beamlets. A beam tube 151 is provided downstream of the multi-aperture arrangement 305, the beam tube 151 being connected to a voltage supply with the first or tube voltage VT. From the entrance of a beam tube 151, the plurality of primary charged particle beamlets 3 is at a constant kinetic energy ET until the exit opening 153 of the beam tube 151. The kinetic energy ET of the primary charged particle beamlets 3 during passing the beam tube 151 is for example 20KeV, 30keV or more.

The plurality of primary charged particle beamlets 3 are imaged and focus points 5.1 to 5.3 are formed in an object plane 101 by field lenses 333 and 103, and by objective lens 102. The objective lens 102 is of the type of a magnetic lens with a coil 161 and a pole shoe 163 with a lower pole shoe segment 165, forming an axial gap for the magnetic field. Other types of magnetic lenses are possible as well, for example radial gap lenses for generation an immersion lens field, or magnetic lenses with several coils and pole shoes. Upstream or partially integrated in the objective lens 102, a beam divider 400 is arranged, configured to separate the secondary electrons along secondary electron beam path 13 to detector unit 200. Below the lower pole shoe segment 165, an electrode 133 is provided, connected to a voltage supply for providing a second voltage VE to the electrode. In the example shown, the electrode 133 is provided as separate electrode.

Via sample voltage supple 503, a sample voltage VL is provided by sample voltage supply 503 to a sample mounting platform 505 for holding and contacting during use a wafer 7. At the surface 25 of the wafer 7, a first material composition 67 is arranged under a first set of primary charged particle beamlets 3.1 and 3.2, and a second material composition 69 is arranged under a second set of primary charged particle beamlet comprising primary charged particle beamlet 3.3. According to the voltage difference between VL and VT, an electrical field 137 is generated, which is almost parallel to the propagation direction of the primary charged particle beamlets 3 and generates a decelerating force to the primary charged particles (figure 2 illustrates equipotential lines of the electrical field 137). The sample voltage VL is adjusted such that the third kinetic energy or landing energy EL of the primary electrons is adjusted in a range below 5keV, below 2keV, below 800eV, below 300eV or even below 100eV. The electrical field 137 forms a decelerating field to reduce the kinetic energy of the primary charged particle beamlets 3 before impinging on the sample surface 25 arranged in the object plane 101, such that a high resolution is achieved. The electrical field 137 also forms an extraction field for extracting and accelerating secondary electrons from the wafer 7. The field 137 is therefore also called the extraction field 137.

The object irradiation system 100 of the multi-beam charged particle beam system 1 shown in Figure 1 and 2 further comprises a collective multi-beam raster scanner 110 in proximity of a beam cross over 108 by which the plurality of charged particle beamlets 3 can be deflected in scanning direction perpendicular to the propagation direction of the charged particle beamlets. The propagation direction of the primary beamlets throughout the examples is in positive z-direction. Objective lens 102 and collective multi-beam raster scanner 110 are centered at an optical axis (not shown) of the multi-beam charged-particle system 1, which is perpendicular to wafer surface 25. The plurality of primary charged particle beamlets 3, forming the plurality of beam spots 5, which are arranged in a raster configuration, is scanned synchronously over the wafer surface 25. In an example, the raster configuration of the focus spots 5 of the plurality of J primary charged particle 3 is a hexagonal raster of about one hundred or more primary charged particle beamlets 3, for example J = 91, J = 100, or J approximately 300 or more beamlets. The primary beam spots 5 have a distance about $6\mu m$ to $45\mu m$ and a diameter of below 5nm, for example 3nm, 2nm or even below. In an example, the beam spot size is about 3nm, and the distance between two adjacent beam spots is $8\mu m$. At each scan position of each of the plurality of primary beam spots 5, a plurality of secondary electrons is generated, respectively, forming the plurality of secondary electron beamlets in the same raster configuration as the primary beam spots 5. The intensity of secondary charged particle beamlets generated at each beam spot 5 depends on the intensity of the impinging primary charged particle beamlet 3, the material compositions 67, 69 and topography of the object 7 under the beam spot 5, and the charging condition of the sample at the beam spot 5. The plurality of secondary charged particle beamlets are accelerated by the same electrostatic field 137 between objective lens 102 and object surface 25 and are collected by objective lens 102 and pass the first collective multi-beam raster scanner 110 in opposite direction to the primary beamlets 3. The plurality of secondary beamlets is scanning deflected by the first collective multi-beam raster scanner 110. The plurality of secondary charged particle beamlets is then guided by secondary electron beam divider or beam splitter unit 400 to follow the secondary beam path 13 to the detection unit 200. The beam splitter unit 400 is configured to separate the secondary beam path 11 from the primary beam path usually by means of magnetic fields or a combination of magnetic and electrostatic fields.

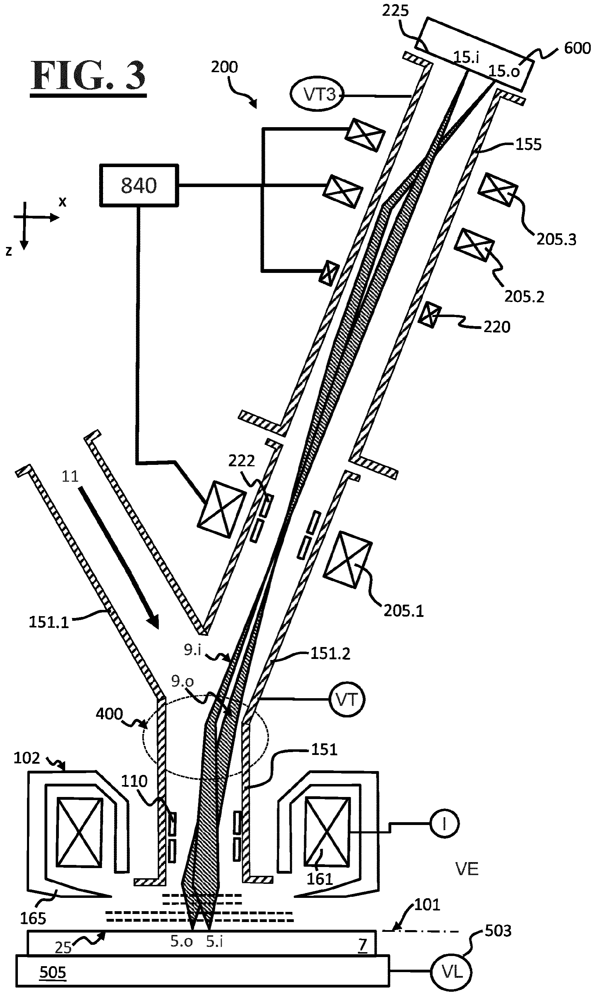

Detection unit 200 images the secondary electron beamlets onto the image sensor 600 to form there a plurality of secondary charged particle image spots 15. **Figure 3** illustrates an example of a detection unit 200 and further components, which are already shown in figure 1 or 2, and which are labelled by same reference numbers. Reference is made to the description of figure 1 and 2. The primary charged particle beamlets are schematically shown by primary beam path 11. The Figure 3 illustrates the secondary electron beam path at the example of two secondary electron beamlets 9.i and 9.o. There are many more secondary electron beamlets, corresponding to the number of the plurality of primary charged particle beamlets, which are focused onto the surface 25 of a sample 7 (with only to focus points 5.o and 5.i shown). The detection unit 200 comprises a second branch 151.2 of the common beam tube 151, which is connected to a voltage supply line and set to tube voltage VT (see also Figure 2). VT can for example be ground potential. Through the tube 151, primary charged particles propagate with constant high kinetic energy of for example E1 = 30keV. The detection unit 200 further comprises a second beam tube segment 155 at tube voltage VT3. In an example, VT and VT3 are identical and all set to ground level. Within the detection unit 200, a first magnetic projection lens 205.1 and a second scanning deflector 222 are arranged. The second raster scanner 222 is connected to scanning control unit 860. Scanning control unit 860 is configured to compensate a difference in the scanning deflection power of the first scanning deflector 110 in the common beam path, such that the positions of the plurality secondary electron focus spots 15 are kept constant at image sensor 600. In this example, the second scanning deflector 222 is a two-stage electrostatic octupole scanner, which is arranged inside the second branch 151.2 of the common beam tube 151. Within the detection unit 200, at least one static deflector or multi-pole corrector 220 for quasi-static adjustment of a secondary electron beam path and two further magnetic projection lenses 205.2 and 205.3 are provided. A pair of two further magnetic projection lenses 205.2 and 205.3 are configured to form the focus spots 15.i, 15.o of the secondary electron beamlets 9.i, 9.o on the image plane 225 and to adjust an image rotation of the secondary electrons beamlets, induced by for example a change of an object plane 101 by objective lens 102. The three magnetic projection lenses 205.1, 205.2 and 205.3 and the quasi-static multi-pole corrector 220 are connected to and controlled by the secondary beam-path control module 840. Additional magneto-dynamic multi-pole deflectors (not shown) may be arranged for a quasi-static adjustment of the beam path 13 of the plurality of secondary electron beamlets 9.

The system 1 may further comprise an optionally retractable monitoring system 230 (see figure 1). Monitoring systems and monitoring methods to detect charging effects at such charging samples are further described in patent applications WO 2022248141 A1 and DE 10 2022 114 923 A1, which are hereby fully incorporated by reference. The detection unit 200 is described in more detail below.

During an acquisition of an image patch by scanning the plurality of primary charged particle beamlets 3, the stage 500 is preferably not moved, and after the acquisition of an image patch, the stage 500 is moved to the next image patch to be acquired. In an alternative implementation, the stage 500 is continuously moved in a second direction while an image is acquired by scanning of the plurality of primary charged particle beamlets 3 with the collective multi-beam raster scanner 110 in a first direction. Stage movement and stage position is monitored and controlled by sensors known in the art, such as Laser interferometers, grating interferometers, confocal micro lens arrays, or similar.

During an image scan, the control unit 800 is configured to trigger the image sensor 600 to detect in predetermined time intervals a plurality of timely resolved intensity signals from the plurality of secondary electron beamlets, and the digital image of an image patch is accumulated and stitched together from all scan positions of the plurality of primary charged particle beamlets 3.

The control unit 800 of the multi-beamlet charged-particle system 1 further comprises an- imaging control module 810, configured to receive the data streams from the image sensor 600 and to generate a digital image of the surface of the sample 7 during operation; a secondary beam-path control module 840, configured to control the detection unit 200; a primary beam-path control module 830, configured to control the elements of the object irradiation unit 100; a stage control module 850, configured to control the stage positioning and alignment, and including control of the sample voltage supply unit 503; a scanning operation control module 860, configured to control a scanning operation by the first collective multi-beam raster scanner 110 and the second deflection system 222; a control operation processor unit 880, configured to execute inspection tasks of samples, and control modules 810, 820, 830, 840, 850, 860; and a memory 890 for storing software, instructions and image data. The control operation processor unit 880 is further connected to an interface IX for exchange of data, instructions, software, or user interaction.

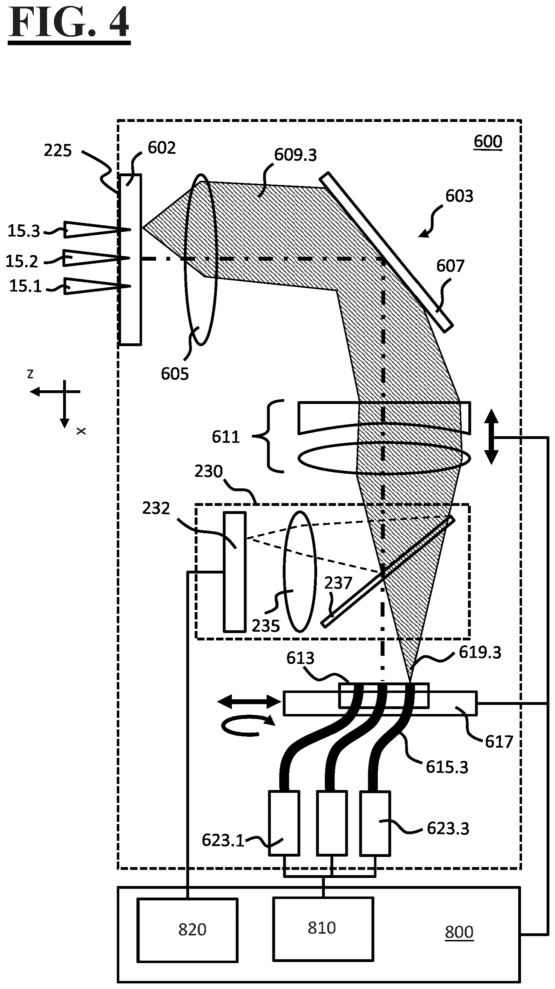

The image sensor 600 is configured by an array of sensing areas in a pattern compatible to the raster arrangement of the secondary electron beamlets focused by the detection unit 200 onto the image sensor 600. This enables a detection of each individual secondary electron beamlet independent from the other secondary electron beamlets incident on the image sensor 600. According to an embodiment of the invention, the image sensor 600 is configured as electron to photon conversion unit or scintillator plate 602 arranged in the focal plane 225 of the plurality of secondary electron particle image spots 15. In this embodiment, as shown in **figure 4,** the image sensor 600 comprises a relay optical system 603 comprising collection lenses 605 and zoom lens 611 for imaging and guiding the photons generated by the electron to photon conversion unit 602 at the secondary charged particle image spots 15 into an image plane 613. In the image plane 613, dedicated photon detection elements 623 can be arranged, such as a plurality of photomultipliers or avalanche photodiodes. Photons generated by the electron to photon conversion unit 602 are forming a plurality of light beams 609, of which only one light beam 609.3 corresponding to secondary electron focus point 15.3 is illustrated in figure 4. With relay optical system 603, photon conversion unit 602 is imaged into the image plane 613, where entrance apertures of light guides 615 are arranged. Each light guide 615 individually receives the light intensity corresponding to a secondary charged particle image spot 15, for example spot 15.1, 15.2 or 15.3, and each light guide 615 is connected to a, individual detection element 623. For example, by relay optical system 603, focus point 619.3 of light beam 609.3 is formed in the image plane 613, and entrance aperture of light guide 615.3 is arranged at the image position of secondary electron focus spot 15.3. Thereby, photons generated at each focus position 15 of each secondary electron beamlet 9 are detected individually. The plurality of light guides can be mounted with regular raster space on a movement stage 617, by which a lateral position of a rotation of the plurality of apertures of light guides 615 can be adjusted according to the position and rotation of the raster of secondary electron beamlets 9 in the image plane 225. Figure 4 shows only three focus spots 15.1 to 15.3, and only three corresponding light guides 615 and detection elements 623. However, it is understood that the number of corresponding light-guides 615 and detection elements 623 can be much larger and their number is at least given by the number J of secondary electron beamlets 9.

The image sensor 600 is further configured with a monitoring system 230, comprising a beam divider mirror 237, an imaging lens 235 and a CMOS sensor 232 with high resolution. Thereby, a position of the plurality of focus spots 15 on the electron to photon conversion unit 602 is monitored during use.

For each of the plurality of secondary charged particle beam spots 15, the intensity is detected separately, and the property of the object surface 25 is detected with high resolution for a large image patch of the object 7 with high throughput. For example, with a raster of 10 x 10 beamlets with $8\mu m$ pitch, an image patch of approximately $88\mu m$ x $88\mu m$ is generated with one image scan with collective multi-beam raster scanner 110, with an image resolution of for example 2nm or below. The image patch is sampled with half of the beam spot size, thus with a pixel number of 8000 pixels per image line for each beamlet, such that the image patch generated by 100 beamlets comprises 6.4 gigapixel. The digital image data is collected by control unit 800. Details of the digital image data collection and processing, using for example parallel processing, are described in international patent application WO 2020/151904 A2 and in US-Patent US 9.536.702, which are hereby incorporated by reference.

When sample charging occurs, however, the trajectories of the secondary electron path are distorted. As a result, the detector 600 is no longer correctly hit by the secondary electron beamlets. In a worst case, this can result in dark images, or in large crosstalk. Due to distortion, the focus points 15 of secondary electron beamlets 9 are displaced and the excited light from the electron to photon conversion unit 602 is not imaged onto corresponding entrance apertures of light guides 615 or detection elements 623.

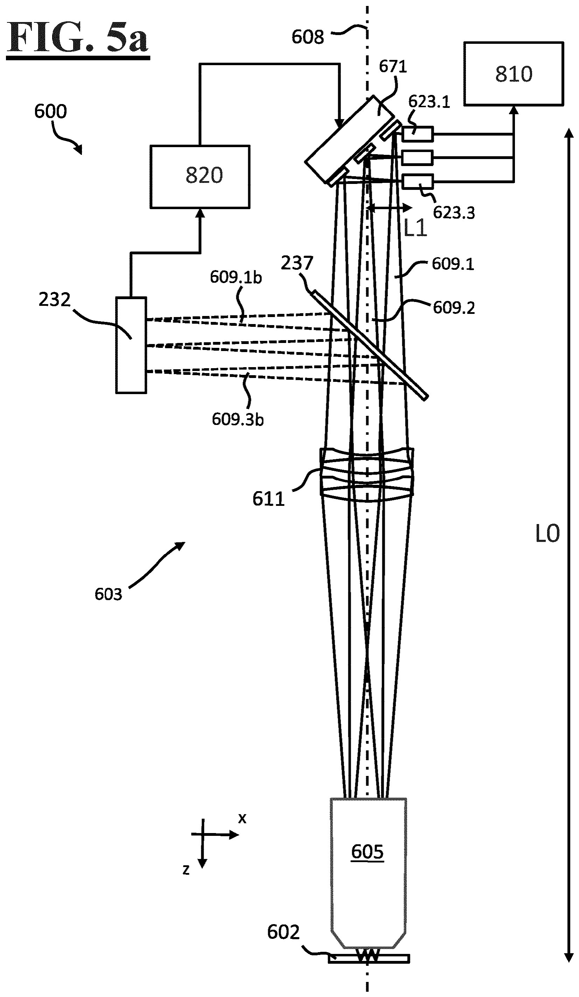

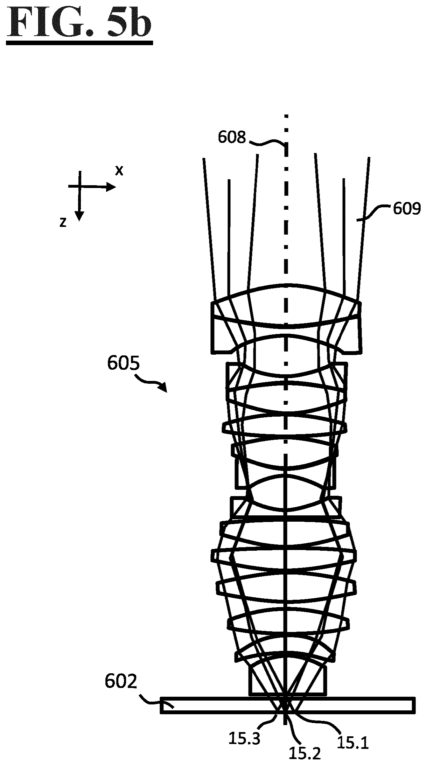

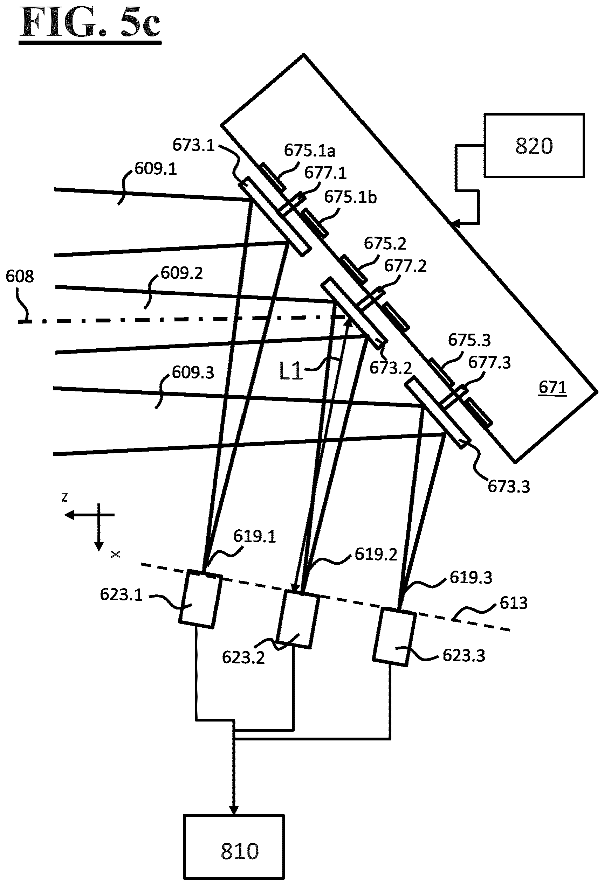

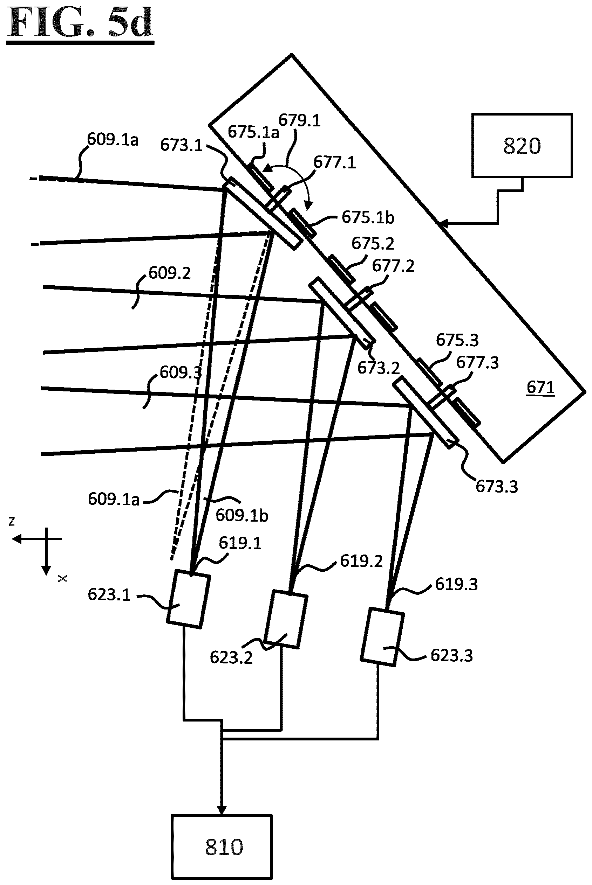

According to an embodiment, the relay optical system 603 therefore comprises an adaptive system for individually adjusting the focus points of the light beams of beam bundles 609. An example is illustrated in **Figure 5. Figure 5a** illustrates an overview of the relay optical system 603 with a collection lens 605, a tube or zoom lens 611, a beam divider 237, a monitoring high resolution sensor 232, an adaptive mirror array 671, and a plurality of detection elements 623 connected to imaging control module 810. Collection lens 605 collects light generated by electron to photon conversion unit 602 and tube or zoom lens 611 focuses the bundles of light beams 609 on the detection elements 623 (or entrance apertures 613 of light guides 615, respectively). At a distance L1 to the detection elements 623, an array of tiltable mirrors in form of an adaptive mirror array 671 is arranged. The distance L1 is selected such that each mirror of the mirror array 671 is intersected by one light beam, for example light beam 609.1, 609.2, each corresponding to one focus point 15 or one individual secondary electron beamlet 9 (see figure 3 and 4). The tilt angles of each tiltable mirror of adaptive mirror array 671 are adjusted such that each individual light beam 609, for example light beam 609.1, is adjusted to intersect corresponding detection element 623.1. Tilt angles are determined by mirror control module 820 according to distorted positions of beamlets 609.1b to 609.3b. Distorted positions of beamlets 609.1b to 609.3b are detected with monitoring high resolution sensor 232. Thereby, during operation, a plurality of secondary electron beamlets 9 is excited at a surface 25 of an object 7 by irradiating the surface 25 of an object 7 with focus points 5 of plurality of primary electron beamlets 3. The plurality of secondary electron beamlets 9 is focused by a detection unit 200 onto an electron to photon conversion unit 602, and a plurality of light beams 609 is excited by an electron to photon conversion unit 602. Each one of the plurality of light beams 609 is corresponding to one of a plurality of secondary electron beamlets 9, which is corresponding to one of the plurality of primary electron beamlets 3, respectively. Each position of an image point of each of the plurality of light beams 609 is detected by monitoring high resolution sensor 232. Mirror control module 820 is configured to determine a distortion of the image points of each of the plurality of light beams 609 and to trigger an adjustment of at least one tilt angle of adaptive mirror array 671, such that image points of each of the plurality of light beams 609 after passing adaptive mirror array 671 are impinging on corresponding entrance apertures of light guides 615 or detection elements 623, respectively. The relay optical system 603 is folded at the adaptive mirror array 671 with a folding angle defined by the angle between the normal to the adaptive mirror array 671 and the axis of symmetry 608 of the collection lens 605.

**Figure 5b** illustrates an example of the collection lens 605. Collection lens 605 can be similar to a microscope lens with a collection aperture of NA = 0.6 or more, for example NA = 0.8. Collection lens 605 can comprise a series of lens elements, for example with ten or more lens elements consisting of single lenses, doublets, or triplets. The lens elements are centered along an optical axis 608.

**Figure 5c** illustrates an example of the adaptive mirror array 671 at a simplified example with three tilt mirrors 673.1, 673.2, 673.3. Each tilt mirror 673.1 to 673.3 is mounted via a hinge 677.1 to 677.3 to mirror body of the adaptive mirror array 671. A plurality of electrode segments 675a, 675b are arranged below each mirror 673. Thereby, a tilt of each mirror 673 can be individually adjusted by an electrostatic force. In addition to plurality of electrode segments 675a, 675b, which acts as actuators, capacitive sensors can be provided to directly monitor a tilt angle of each mirror. Other examples of continuously adjustable tilt angles of mirror arrays are possible as well, involving articulated joints and actuators, for example including piezo actuators, and optionally sensors for active feedback control of the tilt positions of each mirror.

**Figure 5d** illustrates the example where light beam 609.1a is distorted and does not intersect at the center of detection unit 623.1. The displacement of light beam 609.1a is detected by monitoring high resolution sensor 232 (see figure 5a) and a corresponding signal for adjusting the focus position of light beam 609.1a is determined by mirror control module 820 and provided to actuators 675.1a, 675.1b of tilt mirror 677.1.

Thereby, tilt angle 679.1 is adjusted such that light beam 601.a is deflected according to beam path 609.1b and is properly adjusted to intersect with the center of the detection unit 623.1.

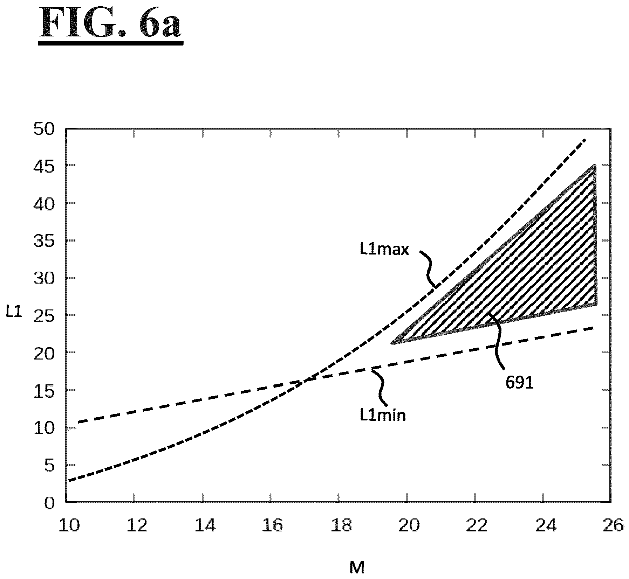

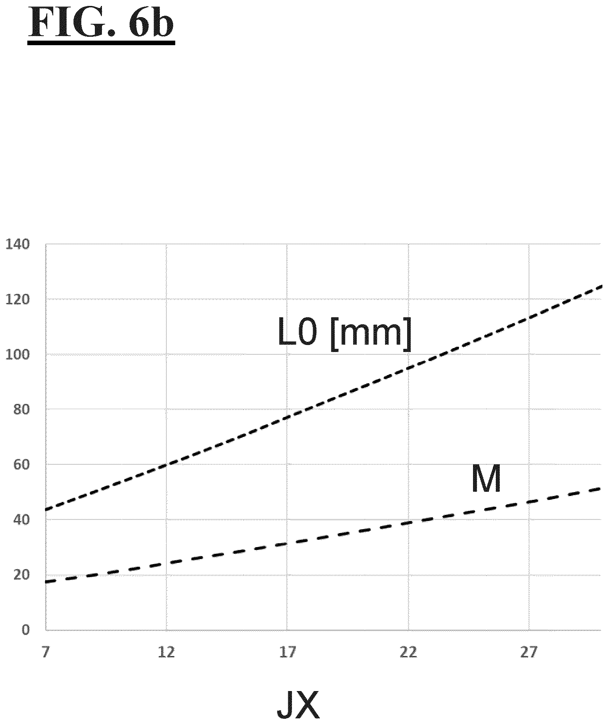

The optical properties of the relay optical system 603 are further illustrated by **figure 6.** A system magnification M of the relay optical system 603 is limited by following properties:

- the pitch P0 of the focus points 15, forming the points of origin of light beams 609; the pitch of beamlets at the detection elements 623 or entrance apertures 613 of lightguides 615 is P1 = M x PO.
- the collection NA0 (numerical aperture, sinus of half opening angle of light collection), for example NA0 > 0.4, for example NA0 >= 0.6, or for example NA0 = 0.8. The numerical aperture at image side at the detection elements 623 or entrance apertures 613 of lightguides 615 is NA1 = NA0 / M.
- the number of beamlets JX in one direction, forming the diameter of the beamlets in the X-direction with D1 = JX x P1.

A distance L1 between adaptive mirror array 671 and image plane, where for example detection units 623 are arranged, must be selected in a way that individual beamlets do not overlap. With a system folding angle of 45°, following condition must be obtained:

$$(1) \qquad L1 < L1max = P1 \times [1/NA1 - JX] / 2.$$

On the other hand, the distance L1 between adaptive mirror array 671 and image plane 613 must exceed the distance

$$(2) \qquad L1 > L1min = JX \times P1 / 2.$$

Since the relay optical system 603 with the adaptive mirror array 671 must allow for some distortion of beamlets to be compensated for, the allowed system solution space 691 has some distance to the conditions (1) and (2) given above.

For a typical example, a number of beamlets JX is nine in a radial direction, with a total number of beamlets J = 61 in a hexagonal arrangement of beamlets. A magnification of a relay optical system 603 is selected to be larger than M = 20. A distance L1 between the adaptive mirror array 671 and the detection units 623, or entrance apertures of light guides, respectively, is between 17mm and 26mm. A total system length of such a relay optical system 603 is about 500mm.

For a typical example, a number of beamlets JX is seventeen, with a total number of beamlets J = 217. In this example, a magnification of a relay optical system 603 is selected to be larger than M = 31. A distance L1 between the adaptive mirror array 671 and the detection units 623, or entrance apertures of light guides, respectively, is between 46mm and 57 mm. A total system length of such a relay optical system 603 is about 770mm.

**Figure 6b** shows a design requirement of the relay optical system 603 for different number of beamlets JX in a radial direction. Pitch P1 is about 3mm to 4mm.

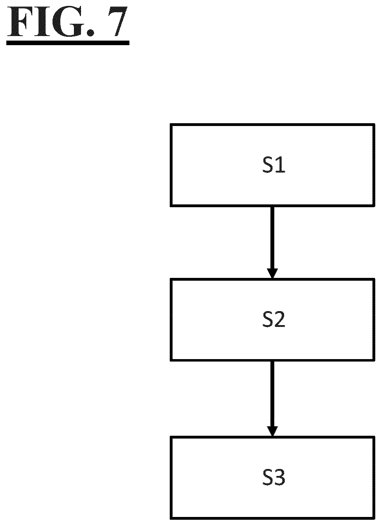

**Figure 7** illustrates a method of operation of a multi-beam charged particle beam system 1.

The method of operating a multi-beam charged particle beam is comprising a **step S1** comprising forming a plurality of first focus spots of a plurality of primary charged particle beamlets in a first image plane and collecting a plurality of secondary electron beamlets and forming a plurality of second focus spots of the plurality of secondary electron beamlets in a second image plane. Step S1 is further comprising converting the plurality of second focus spots into a plurality of light beams and forming a plurality of third focus spots thereof in a third image plane.

In step S1, an image acquisition of a surface 25 of a substrate, for example a wafer 7, is initiated. A plurality of secondary electron beamlets 9 is excited from the surface 25 of the object 7. The plurality of secondary electron beamlets 9 is image onto an electron to photon conversion unit 602 and each beamlet is individually converted into a light beam with an intensity corresponding to the secondary electron yield at the corresponding irradiation position of the object 7. Each signal of each secondary electron beamlets 9 is individually acquired by detection elements 623. A small fraction is separated by optical beam divider mirror 237 and the focus points of the plurality of light beams 609 are monitored by high resolution sensor 232.

The method is further comprising a **step S2** of monitoring the plurality of positions of the plurality of third focus spots with a high-resolution image sensor and determining a deviation in a position of at least one third focus spot from a pre-determined position. Step S2 is further comprising determining from the deviation at least one tilt angle of a mirror of an adaptive mirror array. In step S2, the focus points of the plurality of light beams 609, obtained by high resolution sensor 232, are determined by image processing and compared to target positions of the focus points of the plurality of light beams 609. Such target positions can be previously determined during a system calibration and stored within a memory of the mirror control module 820. Image processing methods are for example described in PCT/EP2024/051248 with filing date of January 19, 2024, which is hereby incorporated by reference.

From the comparison between an actual position and target position, a distortion of each individual beamlet is determined and at least two tilt angles of a corresponding mirror element 673 are determined. The change of tilt angle is for example determined according to a predetermined sensitivity of tilt angle dA per displacement D for each individual mirror 673 for each corresponding beamlet 609.

A method of operating a multi-beam charged particle beam is further comprising **step S3** of individually adjusting a position of at least one third focus spot and receiving a plurality of intensity signals with a plurality of fast detection elements (623). In step S3, the tilt angles determined in Step S2 are applied to each mirror element 673 of the adaptive mirror array 671. Thereby, a position of at least one third focus spot is adjusted by actuation of a corresponding mirror of the adaptive mirror array. Thereby, a position of each third focus spot is individually adjusted by actuation of each corresponding mirror of the adaptive mirror array.

In an example, step S2 and step S3 run continuously during an image acquisition. Thereby, varying charging effects are compensated individually for the plurality of beamlets. Thereby, a distortion of secondary electron beamlets during imaging, for example due to a charging effect of the surface of an object, are compensated.

In an example, the method is further comprising a step of adjusting a position or rotation angle of the plurality of entrance apertures of lightguides connected to the fast detection elements with a movement stage.

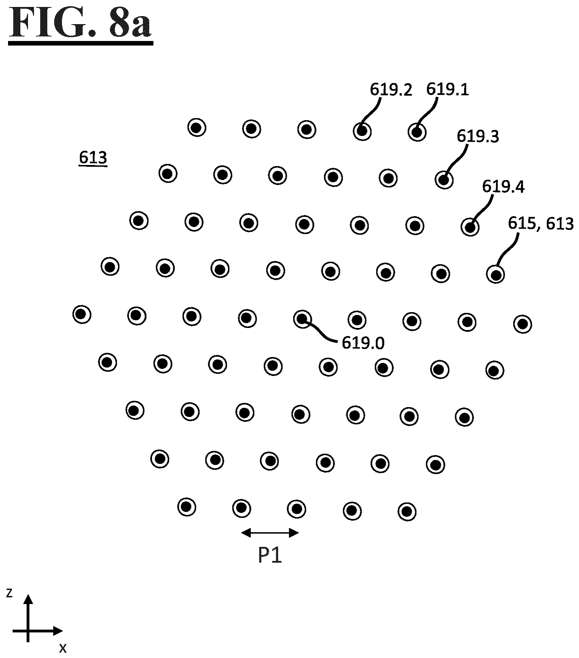

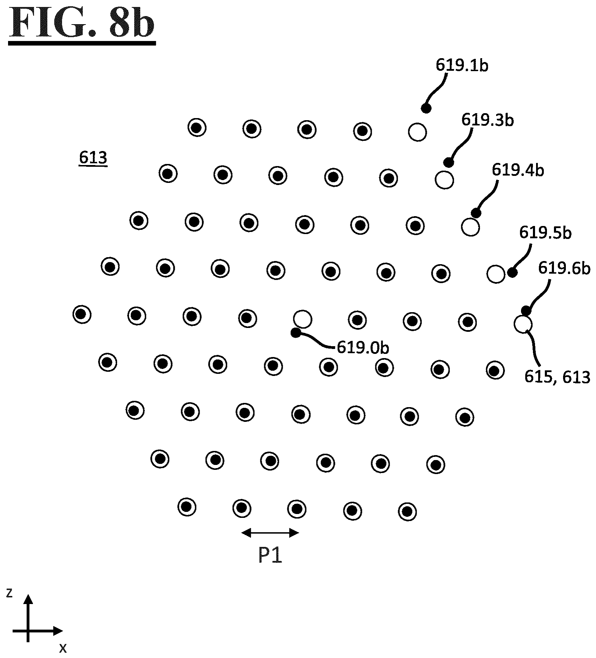

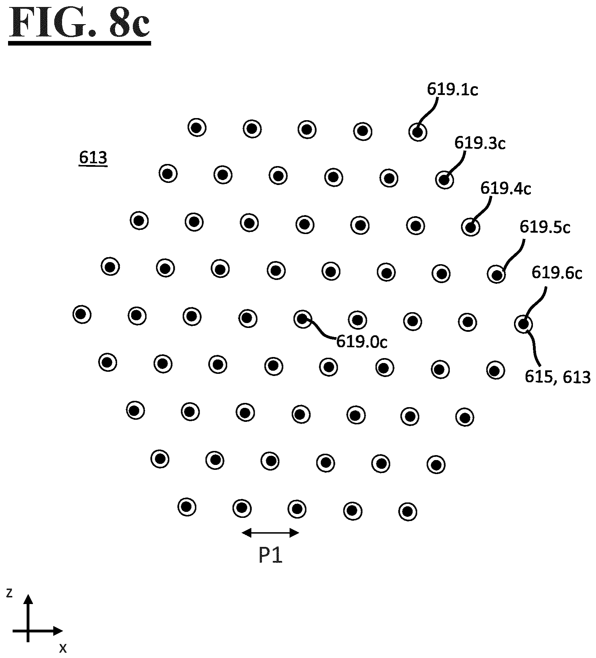

**Figure 8** illustrates an example of an adaptive correction of positions of focus points 619. In figure 8a, an ideal situation of beam spots 619 in the image plane 613 of the relay optical system 613 without charging effects is illustrated. In the example, JX = 9, and the number J of beamlets is J = 61, however, there can be many more beamlets. The plurality of focus points 619 of the beamlets 609 is impinging on a plurality of entrance apertures of light guides 615 or detection elements 623, respectively. The position and rotation angle of the raster of entrance apertures of light guides 615 or detection elements 623 is for example adjusted to the position and rotation of the raster of focus spots 619, including spots 619.0, 619.1 to 619.4, by movement or rotation stage 617. A magnification of the imaging can be adjusted by zoom lens 611.

**Figure 8b** illustrates an example of a charging effect. For example, charging effects may appear at a boundary of an exposure area, here at the focus spots 619.1b, 619.3b, 619.4b, 619.5b and 619.6b at the upper right edge of the exposure area. Such a distortion of beamlets 619.1b, 619.3b, 619.4b, 619.5b and 619.6b would result in a total loss of signal for the beamlets. In addition, local charging effects may distort isolated beamlets, like illustrated at beamlet 619.0b. With the method described above and the adaptive mirror array 671, the individual distortions can be compensated. The distortion of beamlets 619.1b, 619.3b, 619.4b, 619.5b and 619.6b is detected by monitoring system 230, which is for example comprising a high-resolution CMOS camera 232 and a mirror control module 820, comprising a processor which is programmed to continuously perform image processing of images of the CMOS camera 232 and to determine positions of the focus points relative pre-calibrated focus positions. A high-resolution camera 232 has the advantage of high resolution, but the disadvantage of a low image frame frequency of for example below 100Hz. A deviation from a pre-calibrated focus position of each beamlet is converted into two tilt angles of active mirrors 673, and corresponding driving signals are provided to adaptive mirror array 671.

**Figure 8c** illustrates the result of the actuation of adaptive mirror array 671. Focus points 619.0c, 619.1c, 619.3c, 619.4c, 619.5c and 619.6c are again adjusted to the position of entrance apertures of light guides 615 or fast detection elements 623, respectively, and an ideal intensity signal is detected for each charged particle beamlet. With the appropriate fast detection elements 623, for example avalanche photodiodes, high detection frequency according to the scanning frequency of for example 80kHz is possible.

The monitoring is described at the example of using high resolution sensor 232; however, other monitoring systems for active feedback control of the adaptive mirror array are possible as well; for example, the number of entrance apertures of light guides 615 connected to fast detection elements 623 can be larger than the number of the plurality of third focus points, and a distortion can be directly detected by larger number of entrance apertures of light guides 615 connected to a larger number fast detection elements 623. For example, at each ideal third focus spot, three or more entrance apertures of light guides 615 connected to a three ore more fast detection elements 623 can be arranged. Thereby, a change in position of a third focus spot can be detected and a tilt mirror of a corresponding mirror of the adaptive mirror array can be derived.

The invention is not limited to the embodiments or examples described above. The embodiments or examples can be fully or partly combined with one another, and various modifications within the scope of any person of ordinary skill in the art are covered by the disclosure.

A list of reference numbers is provided:

| 1 | multi-beamlet charged-particle system |
|---|---|
| 3 | primary charged particle beamlets, or plurality of primary charged particle beamlets |
| 5 | primary charged particle beam spot |
| 7 | object or sample |
| 9 | secondary electron beamlet, forming the plurality of secondary electron beamlets |
| 13 | secondary electron beam path |
| 15 | secondary electron focus spot |
| 25 | surface of object or sample |
| 67 | first material composition |
| 69 | second material compositon |
| 100 | object irradiation unit |
| 101 | first image plane |
| 102 | objective lens |
| 103 | field lens |
| 108 | first beam cross over |
| 110 | collective multi-beam raster scanner |
| 137 | electric field |

| 151 | beam tube |
|---|---|
| 153 | Beam exit opening |
| 155 | tube segment |
| 161 | coil |
| 163 | pole shoe |
| 165 | lower pole shoe segment |
| 200 | detection unit |
| 205 | magneto-dynamic lens |
| 220 | multi-pole corrector |
| 222 | second raster scanner |
| 225 | secondary electron or second image plane |
| 230 | monitoring system |
| 232 | high resolution sensor |
| 235 | imaging lens |
| 237 | beam divider mirror |
| 300 | charged-particle multi-beamlet generator |
| 301 | charged particle source |
| 303 | collimating lenses |
| 304 | filter plate |
| 305 | primary multi-beamlet-forming unit |
| 306 | multi-aperture plates |
| 309 | primary electron beam |
| 321 | intermediate image surface |
| 331 | first field lens |
| 333 | second field lens |
| 400 | beam splitter or divider unit |
| 500 | sample stage |
| 503 | Sample voltage supply |
| 505 | sample mounting platform or chuck |
| 600 | image sensor |
| 602 | electron to photon conversion unit |
| 603 | relay optical system |
| 605 | collection lens |
| 607 | folding mirror |
| 608 | light optical axis |
| 609 | light beam corresponding to secondary electron beamlet |
| 611 | zoom lens |
| 613 | third image plane |
| 615 | light guide |
| 617 | movement stage |
| 619 | focus spot of light beam |
| 623 | detection element |
| 671 | adaptive mirror array |
| 673 | tilt mirror |
| 675 | electrode or actuator |
| 677 | hinge or flexure |
| 679 | tilt angle |
| 691 | system solution space |
| 800 | control unit |
| 810 | imaging control module |
| 820 | mirror control module |
| 830 | primary beam-path control module |
| 840 | secondary beam-path control module |
| 850 | stage control module |
| 860 | scanning control unit |
| 880 | control operation processor |
| 890 | memory |

## Claims

1. A multi-beam charged particle beam system (1), comprising

   - an object irradiation unit (100), configured for irradiation of a surface (25) of an object (7) arranged in a first image plane (101) with a plurality of first focus spots (5, 5.1, 5.2, 5.3) of a plurality of primary charged particle beamlets (3);
   - a detection unit (200), configured for collecting a plurality of secondary electron beamlets (9, 9.i, 9.o) excited at the plurality of first focus spots (5, 5.1, 5.2, 5.3) from the surface (25) of the object (7), and forming a plurality of second focus spots (15, 15.1, 15.2, 15.3) of the plurality of secondary electron beamlets (9, 9.i, 9.o) in a second image plane (225) of the detection unit (200),
   - an electron to photon conversion unit (602) arranged in the second image plane (225) of the detection unit (200),
   - a relay optical system (603) for imaging light generated at the electron to photon conversion unit (602) and for forming a plurality of third focus spots (619, 619.0 619.1, 619.2, 619.3, 619.4, 619.5) in a third image plane (613) of the relay optical system (603),
   - a plurality of entrance apertures of lightguides (615) or detection elements (623) arranged in the third image plane (613),
   wherein the relay optical system (603) is further comprising an adaptive mirror array (671) and a mirror control module (820) configured for individually controlling tilt angles of a plurality of mirrors (873) of the adaptive mirror array (671) such that the positions of the plurality of third focus points (619, 619.0 619.1, 619.2, 619.3, 619.4, 619.5) are kept constant at the plurality of entrance apertures of lightguides (615) or detection elements (623) during an image acquisition.

2. The system (1) of claim 1, further comprising a monitoring system (230) comprising a high-resolution sensor (232) and wherein the mirror control module (820) is configured to determine position deviations of the plurality of third focus points (619, 619.0 619.1, 619.2, 619.3, 619.4, 619.5) from the plurality of entrance apertures of lightguides (615) or detection elements (623).

3. The system (1) of claim 2, wherein the mirror control module (820) is further configured to determine tilt angles of the adaptive mirror array (671) from the position deviations.

4. The system (1) of any of the claims 1 to 3, wherein the relay optical system (603) has a magnification M >= 20.

5. The system (1) of any of the claims 1 to 4, wherein the adaptive mirror array (671) is arranged at a distance L1 to the third image plane (613) with L1 >= JX x P1 / 2, with

   JX: number of the plurality of beamlets in one lateral direction;
   P1: pitch of third focus spots (619, 619.0 619.1, 619.2, 619.3, 619.4, 619.5).

6. The system (1) of claim 5, wherein L1 is larger than 20mm.

7. The system (1) of any of the claims 1 to 6, wherein each of the plurality of mirrors (673) is an individually and continuously tiltable mirror (673, 673.1, 673.2, 673.3) comprising a flexure (677) and an actuator (675).

8. The system (1) of any of the claims 1 to 7, wherein the plurality of entrance apertures of lightguides (615) or detection elements (623) are mounted on a movement stage (617) for adjustment of a lateral position or rotation angle of the plurality of entrance apertures of lightguides (615) or detection elements (623) with respect to the plurality of third focus spots (619, 619.0 619.1, 619.2, 619.3, 619.4, 619.5).

9. The system (1) of any of the claims 1 to 8, wherein the relay optical system (603) further comprises a zoom lens (611) for adjusting a magnification of the relay optical system (603).

10. A method of operating a multi-beam charged particle beam system (1), comprising:

    - forming a plurality of first focus spots (5, 5.1, 5.2, 5.3) of a plurality of primary charged particle beamlets (3) in a first image plane (101);
    - collecting a plurality of secondary electron beamlets (9, 9.i, 9.o) and forming a plurality of second focus spots (15, 15.1, 15.2, 15.3) of the plurality of secondary electron beamlets (9, 9.i, 9.o) in a second image plane (225);
    - converting the plurality of second focus spots (15, 15.1, 15.2, 15.3) into a plurality of light beams (609, 609.1, 609.2, 609.3) and forming a plurality of third focus spots (619, 619.0 619.1, 619.2, 619.3, 619.4, 619.5) thereof in a third image plane (613),
    - individually adjusting a position of at least one third focus spot (619, 619.0 619.1, 619.2, 619.3, 619.4, 619.5), and
    - receiving a plurality of intensity signals with a plurality of fast detection elements (623, 623.1, 623.2, 623.3).

**11.** The method of claim 10, further comprising

- monitoring the plurality of positions of the plurality of third focus spots (619, 619.0 619.1, 619.2, 619.3, 619.4, 619.5) with a high-resolution image sensor (232),
- determining a deviation in a position of at least one third focus spot (619, 619.0 619.1, 619.2, 619.3, 619.4, 619.5) from a pre-determined position.

**12.** The method of claim 11, further comprising

- determining from the deviation at least one tilt angle (679.1) of a mirror (673, 673.1, 673.2, 673.3) of an adaptive mirror array (671), and
- individually adjusting a position of at least one third focus spot (619, 619.0 619.1, 619.2, 619.3, 619.4, 619.5) by adjusting at least one tilt angle (679.1) of at least one mirror (673, 673.1, 673.2, 673.3) of the adaptive mirror array (671).

**13.** The method of any of the claims 10 to 12, further comprising
- adjusting a position or rotation angle of the plurality of fast detection elements (623, 623.1, 623.2, 623.3) with a movement stage (617).

**14.** The method of any of the claims 10 to 13, further comprising,
- performing an image acquisition of a segment of a surface (25) of an object (7).

**15.** The method of claim 14, wherein the steps are performed in parallel.

**16.** The system (1) of claim 1, further comprising a control unit (800) with software code, causing the multi-beam charged particle beam system (1) to perform a method of any of claims 10 to 15.

**17.** The system (1) of claim 1 or 16, wherein the mirror control module (820) is an ASIC programmed to execute a method according claim 11 or 12.

# FIG.1

# FIG.2

# FIG. 3

# FIG. 4

# FIG. 5a

# FIG. 5b

# FIG. 5c

# FIG. 5d

# FIG. 6a

# FIG. 6b

# FIG. 7

S1

S2

S3

# FIG. 8a

613

619.2 619.1

619.3

619.4

615, 613

619.0

P1

z

x

# FIG. 8b

619.1b

619.3b

613

619.4b

619.5b

619.6b

619.0b

615, 613

P1

z

x

# FIG. 8c

619.1c

619.3c

613

619.4c

619.5c

619.6c

619.0c

615, 613

P1

z

x

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005024881 A2
- WO 2022248141 A1
- DE 102022114923
- DE 102018124044 B3
- US 11049686 BB
- US 10896800 BB
- US 10811215 B2
- WO 2021239380 A1
- DE 102024205080
- WO 2022262970 A1
- US 20190259575 A
- US 10741355 B1
- DE 102022114923 A1
- WO 2020151904 A2
- US 9536702 B
- EP 2024051248 W